# EUROPÄISCHE PATENTANMELDUNG

(11) **EP 2 993 372 A1**
(43) Veröffentlichungstag der Anmeldung: **09.03.2016**
(21) Anmeldenummer: 15177657.2
(22) Anmeldetag: 21.07.2015
(51) Int. Cl.: F16F 7/10, B06B 1/00

(54) **KRAFTGENERATOR MIT DURCH ELEKTRONISCHES BAUELEMENT GEBILDETER INERTIALMASSE SOWIE ANSTEUERSCHALTUNG HIERFÜR**

(30) Priorität: 29.07.2014 DE 102014110753
(71) Anmelder: Airbus Defence and Space GmbH, 85521 Ottobrunn (DE)
(72) Erfinder: Storm, Stefan, 85716 Valerystr. 84 (DE); Maier, Rudolf, 83714 Miesbach (DE)
(74) Vertreter: Flügel Preissner Schober Seidel

(57) **Zusammenfassung**

Die Erfindung betrifft einen Kraftgenerator (10) zum Einleiten von Schwingungskräften in eine Struktur (56) zur Schwingungsbeeinflussung der Struktur (56), mit: einer Inertialmasse (12), wenigstens einem Aktor (14.1, 14.2, 14.3, 14.4) zum Erzeugen einer Schwingbewegung der Inertialmasse (12) relativ zu der Struktur (56) und einer aus Bauelementen (20) aufgebauten elektronischen Ansteuerschaltung (16) zum Ansteuern des wenigstens einen Aktors (14.1, 14.2, 14.3, 14.4). Um das Gesamtgewicht, insbesondere bei piezoelektrisch betätigten Kraftgeneratoren, zu verringern, wird vorgeschlagen, dass die Inertialmasse (12) zumindest zum Teil durch ein Bauelement (20) der Ansteuerschaltung (16) gebildet ist. Außerdem betrift die Erfindung eine Ansteuerschaltung (16), wie insbesondere Verstärker, mit einem als schwingende Masse ausgebildeten Bauelement (20).

## Beschreibung

Die Erfindung betrifft eine Ansteuerschaltung, insbesondere eine Verstärkerschaltung, für einen Kraftgenerator. Weiter betrifft die Erfindung einen Kraftgenerator zum Einleiten von Schwingungskräften in eine Struktur zur Schwingungsbeeinflussung der Struktur, mit: einer Inertialmasse, wenigstens einem Aktor zum Erzeugen einer Schwingbewegung der Inertialmasse relativ zu der Struktur und einer aus Bauelementen aufgebauten elektronischen Ansteuerschaltung zum Ansteuern des wenigstens einen Aktors.

Allgemein betrifft die Erfindung einen Kraftgenerator zur Erzeugung einer auf eine Struktur aufzuerlegenden Kraft mit Hilfe einer Inertialmasse sowie eine Ansteuerschaltung hierfür. Der Kraftgenerator dient insbesondere zur Schwingungsbeeinflussung von Strukturen. Zum Beispiel sind gezielt Gegenschwingungen in eine Struktur einzuleiten, um den Gesamtpegel der Schwingungen in der Struktur zu reduzieren. Derartige Kraftgeneratoren finden z.B. in einer Vorrichtung zur Schwingungsbeeinflussung Anwendung. Die Erfindung findet insbesondere Anwendung bei der Schwingungskontrolle in Hubschraubern und Flugzeugen.

Kraftgeneratoren dienen dazu, mittels einer vorbestimmten Inertialmasse eine gewünschte Kraft zu erzeugen. Die Kraft resultiert dabei aus der Trägheit der wie auch immer bewegten Inertialmasse. Um eine möglichst hohe Kraft zu erzeugen, kann zum einen die Inertialmasse mit einer möglichst hohen Beschleunigung bzw. einer hohen Auslenkung bewegt werden. Alternativ dazu oder zusätzlich lässt sich eine solche hohe Kraft auch durch eine möglichst hohe Inertialmasse generieren.

Kraftgeneratoren werden beispielsweise zum gezielten Einleiten von Kräften in schwingende Strukturen, wie z.B. Luftfahrzeuge, Kraftfahrzeuge oder Maschinen komponenten, verwendet, um z.B. Schwingungspegeln entgegen zu wirken und diese auszulöschen. Kraftgeneratoren zur Schwingungsdämpfung sind auch als Inertialmassenaktoren bekannt. Sie werden z.B. als Zusatzsysteme an bestehende Maschinen oder Vorrichtungen angebracht, um Schwingungen zu reduzieren oder um Prozesskräfte einzuleiten. Kraftgeneratoren oder Inertialmassenaktoren sind z.B. aus einem Feder-Inertialmasse-System ausgebildet, in welches ein Aktor integriert ist. Zum Einsatz kommen dabei z.B. piezoelektrische Aktoren.

Beispiele für Kraftgeneratoren zum Einleiten von Schwingungskräften der in dem Oberbegriff des Anspruchs 1 genannten Art sind aus der WO 2007/073820 A1 und der US 2005/0280332 A1 bekannt.

Bei der WO 2007/073820 A1 wird hierbei eine Inertialmasse an einem Biegearm vorgesehen, der mittels eines oder mehrerer piezoelektrischer Aktoren in Biegeschwingungen versetzt wird. Hierzu ist eine Ansteuerung in Form einer elektronischen Ansteuerschaltung zum Ansteuern des Aktors bzw. der Aktoren vorgesehen.

Beispiele für elektronische Ansteuerschaltungen zum Ansteuern von piezoelektrischen Aktoren von Kraftgeneratoren sind in der EP 0 907 036 A2, der US 2005/0280332 A1, der US 2005/0285477 A1, der US 6 411 009 B2, der US 2008/031667 A1 und der EP 2 733 839 A1 beschrieben und gezeigt.

Bei piezoelektrischen Kraftgeneratoren ist zum Aufbau der elektronischen Ansteuerschaltung ein Verstärker vorgesehen.

Bei bekannten piezoelektrischen Kraftgeneratoren liegt im Vergleich zu elektrodynamischen Systemen der Nachteil vor, dass das Gewicht der benötigten Verstärker prinzipbedingt höher ist. Ursache ist insbesondere eine Induktivität, die bei getakteten Verstärkern zur Glättung der Ausgangsspannung eingesetzt ist.

Der Erfindung liegt die Aufgabe zugrunde, einen Kraftgenerator der eingangs genannten Art derart zu verbessern, dass das Gesamtgewicht verringert ist.

Diese Aufgabe wird durch eine Ansteuerschaltung nach Anspruch 1 sowie einen Kraftgenerator mit den Merkmalen des nebengeordneten Anspruchs gelöst.

Vorteilhafte Ausgestaltungen der Erfindung sind Gegenstand der Unteransprüche.

Gemäß einem ersten Aspekt schafft die Erfindung eine Ansteuerschaltung für einen Kraftgenerator zum Einleiten von Schwingungskräften in eine Struktur, wobei wenigstens ein Bauelement der Ansteuerschaltung als schwingende Masse ausgebildet ist.

Das als schwingende Masse ausgebildete wenigstens eine Bauelement kann z.B. alleine eine schwingende Masse oder Inertialmasse eines mechanischen Resonators oder Kraftgenerators bilden oder es kann mit weiteren schwingenden Massen zu einer schwingenden Gesamtmasse zusammengefügt werden, die die schwingende Gesamtmasse oder die Inertialmasse eines Resonators oder Kraftgenerators bildet.

Gemäß Ausführungsbeispielen der Erfindung kann das als schwingende Masse oder Teil einer schwingenden Gesamtmasse ausgebildete Bauelement z.B. eine Induktivität, ein Kondensator, ein elektrischer Widerstand und/oder ein Transformator sein. Es ist auch möglich, zusätzlich zu dem wenigstens einen Bauelement auch noch weitere Massen, wie z.B. Gewichte, z.B. Metallstücke oder dergleichen als "Tuning-Masse" hinzuzufügen, um ein bestimmte schwingende Gesamtmasse, z.B. zum Einstellen einer gewünschten Resonanzfrequenz zu erhalten.

Es ist z.B. möglich, dass außer des Bauelements der Ansteuerschaltung zusätzlich eine konventionelle Tuning-Masse eingebaut wird, z.B. zur genauen Frequenzabstimmung, vorzugsweise wird hierzu ein metallischer Werkstoff eingesetzt.

Es ist bevorzugt, dass die Ansteuerschaltung als Piezoverstärker zum Ansteuern von Piezoelementen des Kraftgenerators ausgebildet ist oder einen solchen aufweist, wobei eine Induktivität und/oder ein Transformator und/oder eine Kapazität, wie z.B. ein Pufferkondensator, und/oder ein elektrischer Widerstand des Piezoverstärkers als schwingende Masse ausgebildet ist.

Gemäß einem weiteren Aspekt schafft die Erfindung einen Kraftgenerator zum Einleiten von Schwingungskräften in eine Struktur zur Schwingungsbeeinflussung der Struktur, mit einer Inertialmasse, wenigstens einem Aktor zum Erzeugen einer Schwingbewegung der Inertialmasse relativ zu der Struktur und einer aus Bauelementen aufgebauten elektronischen Ansteuerschaltung zum Ansteuern des wenigstens einen Aktors, wobei die Inertialmasse zumindest zum Teil durch ein Bauelement der Ansteuerschaltung gebildet ist.

Es ist bevorzugt, dass der wenigstens eine Aktor wenigstens ein piezoelektrischer Aktor ist.

Es ist bevorzugt, dass der wenigstens eine Aktor ein Piezoscheiben-Aktor ist.

Es ist bevorzugt, dass der wenigstens eine Aktor wenigstens ein piezoelektrisches scheibenförmiges Biegeelement aufweist oder durch ein solches gebildet ist,

Es ist bevorzugt, dass der wenigstens eine Aktor wenigstens einen piezoelktrischen Scheibenbieger aufweist oder durch einen solchen gebildet ist.

Es ist bevorzugt, dass der wenigstens eine Aktor wenigstens einen d31-Scheibenbieger aufweist oder durch einen solchen gebildet ist.

Es ist bevorzugt, dass eine Induktivität der Ansteuerschaltung als Inertialmasse eingesetzt ist.

Es ist bevorzugt, dass die Ansteuerschaltung als getakteter Verstärker zur Glättung einer Ausgangsspannung mit einer zumindest zum Teil als Inertialmasse verwendeten Induktivität ausgebildet ist oder einen solchen Verstärker aufweist.

Es ist bevorzugt, dass zumindest ein Teil der Inertialmasse eine Masse eines Spannungs-Transformators ist.

Eine bevorzugte Ausgestaltung des Kraftgenerators weist einen fluiddynamischen Dämpfer auf.

Es ist bevorzugt, dass zum Bilden des fluiddynamischen Dämpfers ein Gehäuse vorgesehen ist, in dem die Inertialmasse zwischen zwei fluidbefüllten miteinander in Fluidverbindung stehenden Kammerbereichen schwingend bewegbar angeordnet ist.

Es ist bevorzugt, dass die Fluidverbindung zwischen den Kammerbereichen ein einstellbares Drosselelement aufweist.

Es ist bevorzugt, dass das als Inertialmasse dienende Bauelement der Ansteuerschaltung über eine federelastische Verbindung, an der der wenigstens eine Aktor angreift, mit dem Gehäuse verbunden ist.

Es ist bevorzugt, dass die beiden Kammerbereiche durch zumindest eine mit der Inertialmasse zur Mitbewegung verbundene Membran getrennt sind und durch einen Fluidbypasskanal miteinander in Fluidverbindung stehen.

Es ist bevorzugt, dass ein erster und ein zweiter Aktor symmetrisch zu der Inertialmasse ausgebildet und/oder angeordnet sind.

Eine bevorzugte Ausgestaltung der Erfindung ist ausgebildet als piezoelektrischer Inertialkraftgenerator, bei dem eine Induktivität, die Teil einer elektronischen Ansteuerschaltung für die Ansteuerung von piezoelektrischen Aktoren ist, als Inertialmasse verwendet wird. Vorzugsweise wird eine Induktivität eines Verstärkers, der zur Glättung der Ausgangsspannung eingesetzt ist, als Inertialmasse verwendet.

Ein bevorzugtes Kraftgeneratorsystem ist unempfindlich gegen Querbeschleunigung und Feuchte. Ferner ist es bei einer bevorzugten Ausgestaltung möglich, die passive Dämpfungscharakteristik einzustellen bei gleichzeitig guter Wärmeableitung.

Üblicherweise wird bisher bei piezoelektrischen Inertialkraftgeneratoren als Inertialmasse ein passiver Massekörper verwendet, der die Massebilanz im Vergleich zu elektrodynamischen Systemen verschlechtert.

Als Dämpfungsmaterial zur definierten Resonanzüberhöhung wird bisher vorzugsweise ein Festkörper (Elastomer) gewählt, der in der Designphase oder Konstruktionsphase definiert wird. Nach dem Zusammenbau ist bei bisher bekannten Inertialmasse-Kraftgeneratoren keine Anpassung der Dämpfungscharakteristik mehr möglich.

Weitere Nachteile bisheriger Kraftgeneratoren sind die Nichtlinearität, Alterung und Erwärmung. Ein einfacher Biegebalken als Federelement koppelt in verschiedenen Bewegungsrichtungen und ist somit störanfällig gegenüber Querbeschleunigungen.

Gemäß einer besonders bevorzugten Ausgestaltung wird als Inertialmasse die Masse eines Spannungs-Transformators eingesetzt. Die Masse eines Spannungs-Transformators, der nicht nur die getaktete Ausgangsspannung eines Class-D Verstärkers - Audio-Verstärker - glättet, sondern zusätzlich die benötigte Hochspannung generiert, ist als Inertialmasse besonders geeignet.

Vorzugsweise ist ein Gehäuse vorgesehen. Das Gehäuse des Inertialkraftgenerators ist vorzugsweise geschlossen und mit einem Schutzgas als Fluid gefüllt. Als Schutzgas kann z.B. SF6 eingefüllt sein. Das Gehäuse hat vorzugsweise äußere Hohlräume als Kammerbereiche, die durch einen Kanal in der Gehäusewand verbunden sind. Als Drosselelement kann insbesondere ein einstellbares Ventil dienen. Das einstellbare Ventil in dem Kanal bestimmt die Dämpfung und leitet die entstehende Wärme in das Gehäuse.

Vorzugsweise kann man zur Kraftgenerierung eine geradzahlige Anzahl von piezoelektrischen d31-Scheibenbiegern zum Einsatz, die symmetrisch zur schwingenden Masse angeordnet und somit unempfindlich gegen Querbeschleunigungen sind.

Vorteile von besonders bevorzugten Ausgestaltungen der Erfindung sind:
o geringe Masse des Aktuator-Verstärkersystems,
o robust gegen Querbeschleunigungen,
o einstellbare Dämpfungscharakteristik,
o gute Wärmeableitung der dissipierten Energie über die Gehäusewand,
o geschlossenes System,
o die elektronische Ansteuerschaltung kann eine günstige Verstärkertechnologie bestehend aus handelsüblichem Audioverstärker und Spannungstransformator nutzen, und/oder
o herkömmliche piezoelektrische Scheibenbieger sind als Aktoren nutzbar.

Im Folgenden werden Ausführungsbeispiele der Erfindung anhand der beigefügten Zeichnungen näher erläutert. Dabei zeigen:
- Fig. 1: eine schematische Schnittdarstellung einer ersten Ausführungsform eines Kraftgenerators;
- Fig. 2: eine schematische Schnittdarstellung einer zweiten Ausführungsform eines Kraftgenerators;
- Fig. 3: eine perspektivische Darstellung einer Kombination aus Inertialmasse und einem ersten und zweiten piezoelektrischen Aktor, welcher in den Kraftgeneratoren der Fig. 1 und 2 verwendbar ist;
- Fig. 4: ein Blockschaltbild einer Ausführungsform eines als Ansteuerschaltung oder als Teil einer Ansteuerschaltung für den Kraftgenerator einzusetzenden Verstärkers; und
- Fig. 5: ein Blockschaltbild einer weiteren Ausführungsform eines als Ansteuerschaltung oder als Teil einer Ansteuerschaltung für den Kraftgenerator einzusetzenden Verstärkers.

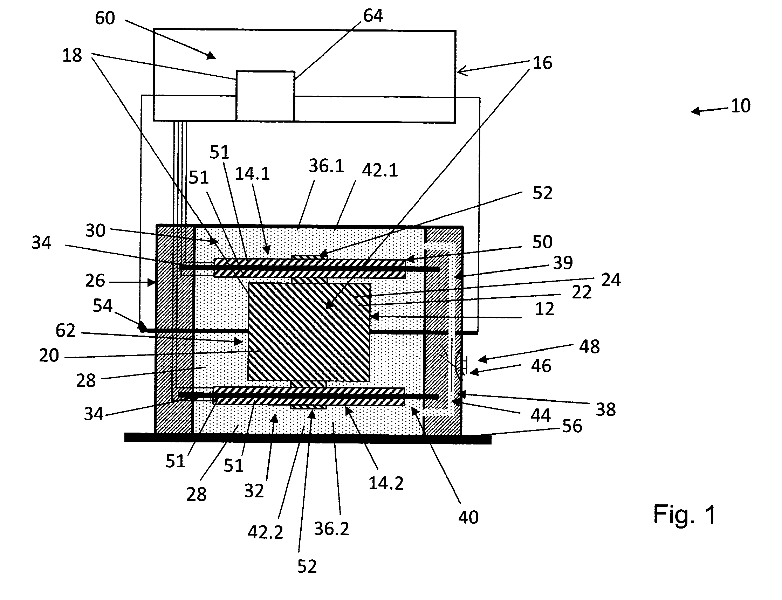

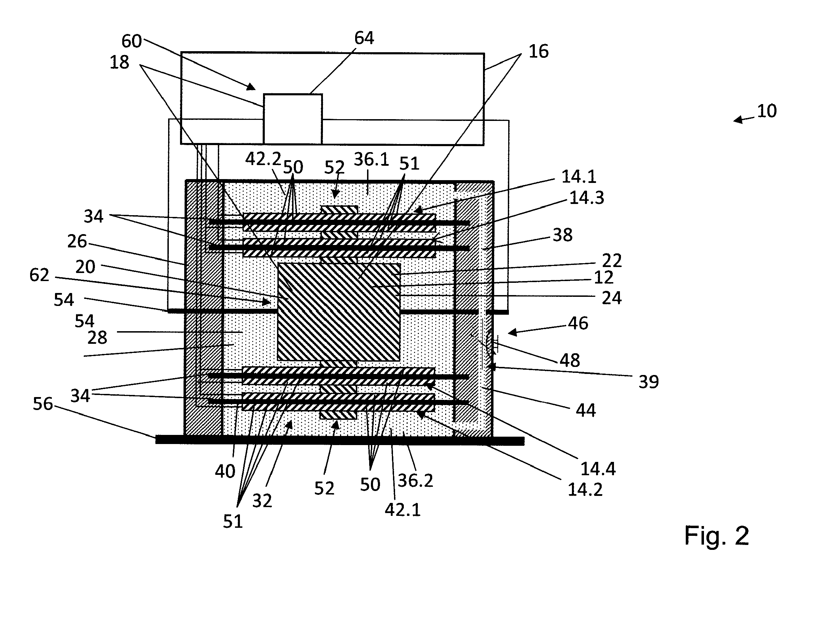

Die Fig. 1 und 2 zeigen zwei Ausführungsbeispiele eines Kraftgenerators 10, welcher eine Inertialmasse 12 und wenigstens einem Aktor 14.1, 14.2, 14.3, 14.4 aufweist.

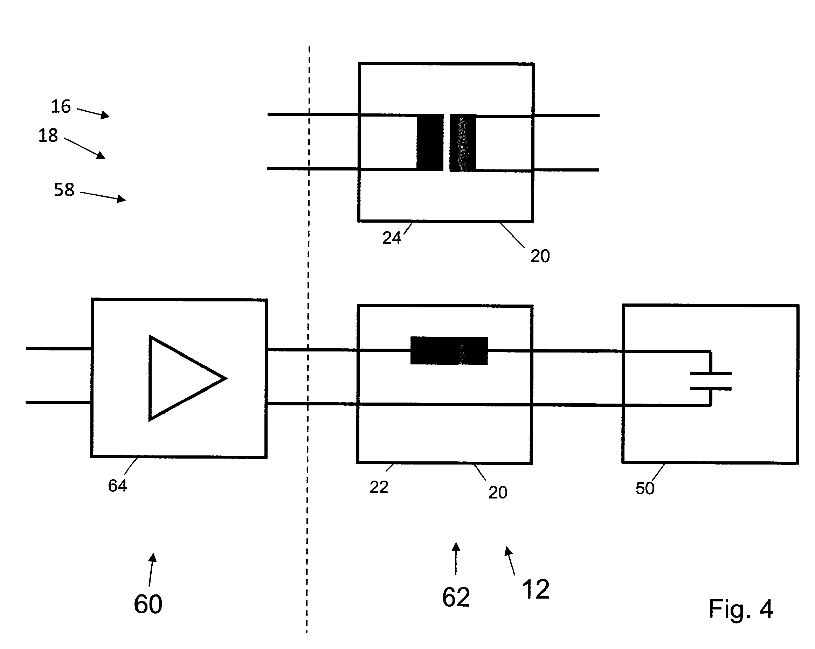

Weiter ist eine elektronische Ansteuerschaltung 16 zum Ansteuern des wenigstens einen Aktors 14.1, 14.2, 14.3, 14.4 vorgesehen. Die in Fig. 1 nur als Blockdarstellung gezeigte Ansteuerschaltung 16 kann einen Aufbau haben, wie er näher in der EP 2 733 839 A1 erläutert ist. Die elektronische Ansteuerschaltung 16 weist einen Verstärker 18 auf, der als ein elektrisches oder elektronisches Bauelement 20 eine Induktivität 22 aufweist. Ein Blockschaltbild des Verstärkers 18 ist in Fig. 4 wiedergegeben.

In dem dargestellten Beispiel ist als Induktivität 22 ein Spannungstransformator 24 vorgesehen, der wenigstens eine Spule und einen Kern aufweist und eine entsprechend schwere Masse darstellt. Die Masse des Spannungstransformators 24 oder allgemeiner der Induktivität 22 wird als Inertialmasse 12 verwendet.

Der Kraftgenerator 10 weist bei den dargestellten Ausführungsbeispielen ein geschlossenes Gehäuse 26 auf, das mit einem Fluid 28 befüllt ist. Als Fluid 28 ist beispielsweise ein Schutzgas 30, z.B. SF6, verwendet.

In dem Innenraum des Gehäuses 26 ist ein aus den Aktoren 14.1, 14.2, 14.3, 14.4 und der Inertialmasse 12 gebildeter Inertialmasseaktor 32 angeordnet.

Der aus der durch den Spannungstransformator 24 bzw. die Induktivität 22 gebildeten Inertialmasse 12 sowie wenigstens einem Paar 14.1, 14.2 der Aktoren und einem Federelement 34 gebildete Inertialmasseaktor 32 trennt das Gehäuse 26 in wenigstens zwei Kammerbereiche 36.1, 36.2, die miteinander in Fluidverbindung 38 stehen.

Das System aus Kammerbereichen 36.1, 36.2 mit Fluidverbindung 38 bildet einen fluiddynamischen Dämpfer 39 für den Kraftgenerator 10.

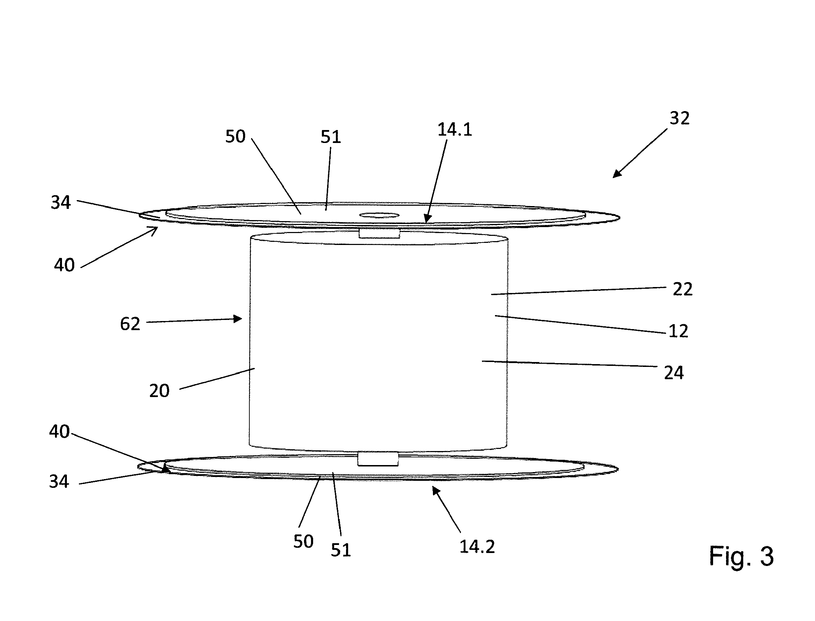

Wie insbesondere aus Fig. 3 ersichtlich, weist der Inertialmasseaktor 32 z.B. wenigstens zwei membranartige Federelemente 34 auf, wobei ein erster Aktor 14.1 einem ersten Federelement 34 und ein zweiter Aktor 14.2 einem zweiten Federelement 34 zugeordnet ist. Die Federelemente 34 bilden zusammen mit den Aktoren 14.1, 14.2 jeweils eine Trennmembran 40, so dass ein erster und ein zweiter äußerer Hohlraum 42.1, 42.2 als Kammerbereiche 36.1, 36.2 gebildet sind.

Zum Bilden der Fluidverbindung 38 ist zwischen den äußeren Hohlräumen 42.1, 42.2 ein Fluidbypasskanal 44 vorgesehen, dessen Durchflussquerschnitt durch ein Drosselelement 46, insbesondere ein einstellbares Drosselventil 48, einstellbar ist. Hierdurch ist die Dämpfung des fluiddynamischen Dämpfers 39 einstellbar.

Zum Bilden der Aktoren 14.1, 14.2, 14.3, 14.4 kommt eine geradzahlige Anzahl von Piezoelementen 50, insbesondere von piezoelektrischen d31-Scheibenbiegern 51, zum Einsatz, die symmetrisch zur schwingenden Inertialmasse 12 angeordnet sind und diese über die Federelemente 34 mit dem Gehäuse 26 verbinden.

Durch Ansteuerung der Aktoren 14.1, 14.2, 14.3, 14.4 mittels der elektronischen Ansteuerschaltung 16 werden die Aktoren betätigt, um die Inertialmasse 12 relativ zu dem Gehäuse 26 zu bewegen und insbesondere in Schwingung zu versetzen.

Auf der der Inertialmasse 12 entgegengesetzten Seite kann sich an den jeweils außen angeordneten Aktoren 14.1, 14.2 und/oder an einer Verbindung derselben mit der Inertialmasse 12 ein End-Stopp 52 befinden, der die Amplitude der Auslenkung durch Anschlag an der Innenwand des Gehäuses 26 begrenzt.

Die als Inertialmasse 12 wirkende Induktivität 22, insbesondere der Spannungstransformator 24, ist mittels elektrischer Leitungen 54 an dem verbleibenden, außerhalb des Gehäuses 26 angeordneten Teil der elektronischen Ansteuerschaltung 16 bzw. an eine Spannungsquelle (nicht dargestellt) angeschlossen.

Bei dem in Fig. 1 dargestellten ersten Ausführungsbeispiel sind ein erster Aktor 14.1 und ein zweiter Aktor 14.2 vorgesehen. Die in Fig. 2 dargestellte zweite Ausführungsform unterscheidet sich von der ersten Ausführungsform dadurch, dass noch ein dritter Aktor 14.3 und ein vierter Aktor 14.4 eingesetzt sind. Ansonsten entspricht die zweite Ausführungsform der in Fig. 1 dargestellten ersten Ausführungsform.

Das Gehäuse 26 kann Teil einer Struktur 56 sein, auf die Schwingungskräfte durch den Kraftgenerator 10 zur Schwingungsdämpfung eingeleitet werden sollen. Alternativ kann das Gehäuse 26 zum Anbringen oder zum Anordnen an eine derartige Struktur 56 ausgebildet sein. Die Struktur 56 kann z.B. ein mechanisches Bauteil eines Luftfahrzeuges, insbesondere eines Hubschraubers, sein.

Fig. 4 zeigt eine Prinzipskizze des Verstärkers 18. Der Verstärker 18 ist als Piezoverstärker 58 ausgebildet und weist einen feststehenden Teil 60 und einen schwingenden Teil 62 auf. Der feststehende Teil 60 weist einen Vorverstärker 64 auf. Der schwingende Teil 62 weist die Induktivität 22 auf, die eine geglättete Spannung an das jeweilige Piezoelement 50 liefert. In dem in Fig. 4 dargestellten Ausführungsbeispiel ist in dem schwingenden Teil 62 außerdem der Spannungstransformator 24 zum Liefern einer Versorgungsspannung für den Piezoverstärker 58 und/oder die gesamte Ansteuerschaltung 16 und somit den Kraftgenerator 10 untergebracht. Die Induktivität 22 kann ein Teil des Spannungstransformators 24 oder ein daran angebrachtes induktives Bauelement (z.B. Spule) sein. Der schwingende Teil 62 des Verstärkers 18 wird als schwingende Masse oder Inertialmasse 12 genutzt.

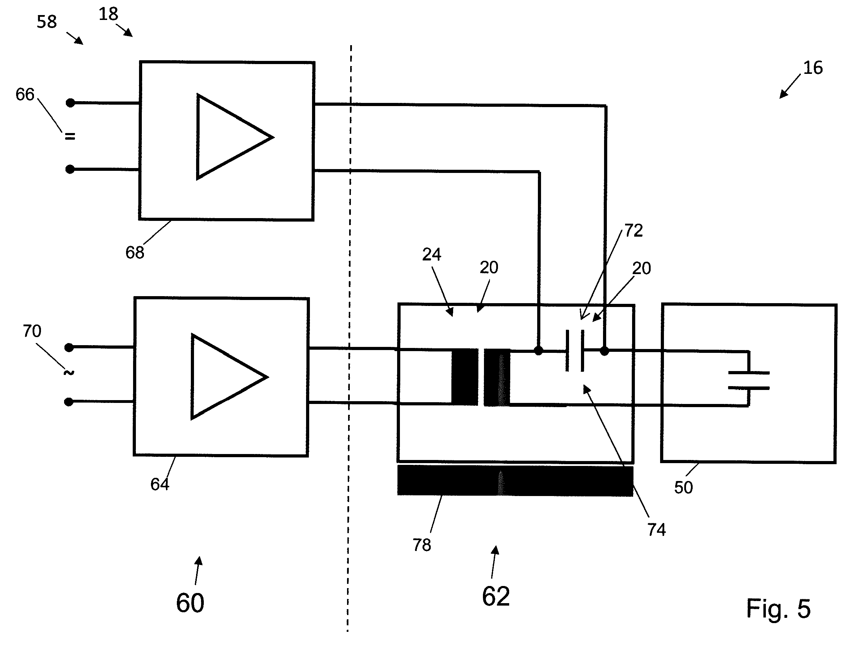

Fig. 5 zeigt die Prinzipskizze einer weiteren Ausführungsform des Verstärkers 18, der ebenfalls als Piezoverstärker 58 zum Ansteuern der Piezoelemente 50 ausgebildet ist und den feststehenden Teil 60 und den schwingenden Teil 62 aufweist.

Im feststehenden Teil 60 ist ein erster Vorverstärker 64 an eine Wechselspannung 66 angeschlossen und ein zweiter Vorverstärker 68 ist an eine Gleichspannung 70 angeschlossen.

In dem schwingenden Teil 62 sind als Bauelemente 20 zum Bilden zumindest eines Teils der Inertialmasse 12 der Spannungstransformator 24 und eine Kapazität 72 in Form eines Puffer-Kondensators 74 vorgesehen. Der Spannungstransformator 24 ist an den ersten Vorverstärker 64 angeschlossen, und der zweite Vorverstärker 68 liefert eine Gleichspannung an den Puffer-Kondensator 74, der in Reihe zwischen dem Sekundärausgang des Spannungstransformators 24 und dem Eingang des anzusteuernden Piezoelements 50 geschaltet ist.

Mit dieser Schaltung lässt sich dem Piezoelement 50 eine Offsetspannung aufprägen. Hierfür wird ein Transformator 24 und ein Puffer-Kondensator 74 als schwingende Masse eingesetzt. Zum Beispiel ist die Kapazität ca. 10mal größer als die des Piezoselements 50. Dies ist ein Beispiel dafür, dass auch ein Kondensator 74,oder auch ein elektrischer Widerstand (nicht dargestellt) als schwingende Masse ausgebildet werden können.

Es ist bei allen Ausführungsbeispielen durchaus möglich, dass außer dem wenigstens einen Bauelement 20 der Ansteuerschaltung 16 zusätzlich eine konventionelle Tuning-Masse eingebaut wird. So ist in Fig. 5 angedeutet, dass zur genauen Frequenzabstimmung eine zusätzliche Masse 78, vorzugsweise ein Gewicht aus metallischen Werkstoff, vorgesehen ist, um die Inertialmasse 12 zusammen mit den Bauelementen 20 zu bilden.

### Bezugszeichenliste:

- 10: Kraftgenerator
- 12: Inertialmasse
- 14.1: erster Aktor
- 14.2: zweiter Aktor
- 14.3: dritter Aktor
- 14.4: vierter Aktor
- 16: elektronische Ansteuerschaltung
- 18: Verstärker
- 20: Bauelement
- 22: Induktivität
- 24: Spannungstransformator
- 26: Gehäuse
- 28: Fluid
- 30: Schutzgas
- 32: Kombination
- 34: Federelement (federelastische Verbindung)
- 36.1: erster Kammerbereich
- 36.2: zweiter Kammerbereich
- 38: Fluidverbindung
- 39: fluiddynamischer Dämpfer
- 40: Trennmembran
- 42.1: erster äußerer Hohlraum
- 42.2: zweiter äußerer Hohlraum
- 44: Fluidbypasskanal
- 46: Drosselelement
- 48: einstellbares Drosselventil
- 50: Piezoelement
- 51: Scheibenbieger
- 52: End-Stopp
- 54: Elektrische Leitung
- 56: Struktur
- 58: Piezoverstärker
- 60: feststehender Teil (des Verstärkers)
- 62: schwingender Teil (des Verstärkers)
- 64: Vorverstärker
- 66: Wechselspannung
- 68: Vorverstärker
- 70: Gleichspannung
- 72: Kapazität
- 74: (Puffer-)Kondensator
- 78: zusätzliche Masse

## Patentansprüche

1. Ansteuerschaltung (16) für einen Kraftgenerator (10) zum Einleiten von Schwingungskräften in eine Struktur (56), **dadurch gekennzeichnet,**
**dass** wenigstens ein Bauelement (20) der Ansteuerschaltung (16) als schwingende Masse ausgebildet ist.

2. Ansteuerschaltung (16) nach Anspruch 1,
**dadurch gekennzeichnet,**
**dass** die Ansteuerschaltung (16) als Piezoverstärker (58) ausgebildet ist oder einen solchen aufweist, wobei eine Induktivität (22) und/oder ein Transformator (24) und/oder eine Kapazität (72) und/oder ein elektrischer Widerstand des Piezoverstärkers (58) als schwingende Masse ausgebildet ist.

3. Kraftgenerator (10) zum Einleiten von Schwingungskräften in eine Struktur (56) zur Schwingungsbeeinflussung der Struktur (56), mit:
einer Inertialmasse (12), wenigstens einem Aktor (14.1, 14.2, 14.3, 14.4) zum Erzeugen einer Schwingbewegung der Inertialmasse (12) relativ zu der Struktur (56) und einer aus Bauelementen (20) aufgebauten elektronischen Ansteuerschaltung (16) zum Ansteuern des wenigstens einen Aktors (14.1, 14.2, 14.3, 14.4),
**dadurch gekennzeichnet,**
**dass** die Inertialmasse (12) zumindest zum Teil durch ein Bauelement (20) der Ansteuerschaltung (16) gebildet ist.

4. Kraftgenerator nach Anspruch 3,
**dadurch gekennzeichnet,**
**dass** die Ansteuerschaltung (16) eine Ansteuerschaltung nach einem der Ansprüche 1 oder 2 ist.

5. Kraftgenerator (10) nach Anspruch 3 oder 4,
**dadurch gekennzeichnet,**
**dass** der wenigstens eine Aktor (14.1, 14.2, 14.3, 14.4) wenigstens ein piezoelektrischer Aktor ist.

6. Kraftgenerator (10) nach Anspruch 5,
**dadurch gekennzeichnet,**
**dass** der wenigstens eine Aktor (14.1, 14.2, 14.3, 14.4) ein Piezoscheiben-Aktor ist, der wenigstens ein piezoelektrisches scheibenförmiges Biegeelement und/oder wenigstens einen d31-Scheibenbieger (51) aufweist.

7. Kraftgenerator (10) nach einem der voranstehenden Ansprüche,
**dadurch gekennzeichnet,**
**dass** eine Induktivität (22) der Ansteuerschaltung (16) als Inertialmasse (12) eingesetzt ist.

8. Kraftgenerator (10) nach einem der voranstehenden Ansprüche,
**dadurch gekennzeichnet,**
**dass** die Ansteuerschaltung (16) einen getakteten Verstärker (18) zur Glättung einer Ausgangsspannung mit einer zumindest zum Teil als Inertialmasse (12) verwendeten Induktivität (22) aufweist.

9. Kraftgenerator (10) nach einem der voranstehenden Ansprüche,
**dadurch gekennzeichnet,**
**dass** zumindest ein Teil der Inertialmasse (12) eine Masse eines Spannungs-Transformators (24) ist.

10. Kraftgenerator (10) nach einem der voranstehenden Ansprüche, **gekennzeichnet durch** einen fluiddynamischen Dämpfer (39).

11. Kraftgenerator (10) nach Anspruch 10,
**dadurch gekennzeichnet,**
**dass** zum Bilden des fluiddynamischen Dämpfers (39) ein Gehäuse (26) vorgesehen ist, in dem die Inertialmasse (12) zwischen zwei fluidbefüllten miteinander in Fluidverbindung (38) stehenden Kammerbereichen (36.1, 36.2) schwingend bewegbar angeordnet ist.

12. Kraftgenerator (10) nach Anspruch 11,
**dadurch gekennzeichnet,**
**dass** die Fluidverbindung (38) zwischen den Kammerbereichen (36.1, 36.2) ein einstellbares Drosselelement (46) aufweist.

13. Kraftgenerator (10) nach einem der Ansprüche 11 oder 12,
**dadurch gekennzeichnet,**
**dass** das als Inertialmasse (12) dienende Bauelement (20) der Ansteuerschaltung (16) über eine federelastische Verbindung (34), an der der wenigstens eine Aktor (14.1, 14.2, 14.3, 14.4) angreift, mit dem Gehäuse (26) verbunden ist.

14. Kraftgenerator (10) nach einem der Ansprüche 11 bis 13,
**dadurch gekennzeichnet,**
**dass** die beiden Kammerbereiche (36.1, 36.2) durch zumindest eine mit der Inertialmasse (12) zur Mitbewegung verbundene Membran (40) getrennt sind und durch einen Fluidbypasskanal (44) miteinander in Fluidverbindung (38) stehen.

15. Kraftgenerator (10) nach einem der voranstehenden Ansprüche,
**dadurch gekennzeichnet,**
**dass** ein erster und ein zweiter Aktor (14.1, 14.2) symmetrisch zu der Inertialmasse (12) ausgebildet und/oder angeordnet sind.
